(19) Europäisches Patentamt
European Patent Office
Office européen des brevets

(11) Veröffentlichungsnummer: **0 214 665**
**A2**

# (12) EUROPÄISCHE PATENTANMELDUNG

(21) Anmeldenummer: 86112561.5

(22) Anmeldetag: 10.09.86

(51) Int. Cl.[4]: C 08 F 2/50
G 03 C 1/68

(30) Priorität: 10.09.85 DE 3532250

(43) Veröffentlichungstag der Anmeldung:
18.03.87 Patentblatt 87/12

(84) Benannte Vertragsstaaten:
AT BE CH DE FR GB IT LI NL

(71) Anmelder: WACKER-CHEMIE GMBH
Prinzregentenstrasse 22
D-8000 München 22(DE)

(72) Erfinder: Trieschmann, Christa, Dr. Dipl.-Chem.
Stadtplatz 95/96
D-8263 Burghausen(DE)

(72) Erfinder: Müller, Johann
Friedrich-Ebert-Strasse 3
D-8263 Burghausen(DE)

(72) Erfinder: Doskocil, Walter
Wacker-Strasse 56
D-8263 Burghausen(DE)

(72) Erfinder: Tosch, Pius
Friedrichsdorf 63
A-5145 Neukirchen/E.(AT)

## (54) Benzoin-Derivate, Verfahren zu ihrer Herstellung und durch Licht vernetzbare Zusammensetzungen, die solche Derivate enthalten.

(57) Benzoin-Derivate, die durch Umsetzung von Benzoin oder einem Derivat des Benzoins, das noch die Hydroxylgruppe des Benzoins enthält, mit tertiärem Amin in Abwesenheit von direkt an Silicium gebundenem Halogen, von Säure, die saurer ist als Benzoin bzw. als das jeweils verwendete Benzoin-Derivat, von Base, die basischer ist als das jeweils verwendete tertiäre Amin und von 1000 Gewichtsprozent, bezogen auf das Gesamtgewicht der jeweils eingesetzten Menge von tertiärem Amin und Benzoin bzw. mit tertiärem Amin umzusetzendem Benzoin-Derivat, übersteigenden Mengen von Stoff, dessen Vernetzung durch Licht initiiert werden soll, erhältlich bzw. hergestellt worden sind, sind neu. Sie eignen sich ausgezeichnet als Initiatoren in durch Licht vernetzbaren Zusammensetzungen.

EP 0 214 665 A2

W A C K E R - C H E M I E
G M B H

München, den 23.07.1985
Dr.Ru/rei

0214665

Wa 8428-S

# Benzoin-Derivate, Verfahren zu ihrer Herstellung und durch Licht vernetzbare Zusammensetzungen, die solche Derivate enthalten

Beispielsweise aus DE-OS 33 31 157 (offengelegt 14. März 1985, A. Hanne et al., BASF AG) und European Patent Application 01 28 321 (veröffentlicht 19. Dezember 1984, F.A. Via, Stauffer Chemical Company) sind durch Licht vernetzbare Zusammensetzungen, welche Benzoin bzw. Benzoin-Derivate und tertiäre Amine enthalten, bekannt. Weiterhin ist es aus US 4 337 348 (veröffentlicht 29. Juni 1982, M. Takamizawa et al., Shin-Etsu Chemical Company Limited) bekannt, beispielsweise ein Produkt, das durch Umsetzung von Benzoin mit Heptamethylchlorcyclotetrasiloxan und Triethylamin hergestellt wurde, als Initiator in durch Licht vernetzbaren Zusammensetzungen zu verwenden.

Es ist Aufgabe der Erfindung, neue Benzoin-Derivate bereitzustellen, welche nicht nur bei Bestrahlung mit Ultraviolett-Licht, sondern auch bei Bestrahlung mit Licht mit einer Wellenlänge von 400 bis 600 nm, also sogenanntem "Halogenlicht", wirksam sind und eine Vernetzung auch in Tiefen der zu vernetzenden Schichten von mindestens 3 mm bewirken. Diese Aufgabe wird durch die Erfindung gelöst.

Gegenstand der Erfindung sind Benzoin-Derivate, dadurch gekennzeichnet, daß sie durch Umsetzung von Benzoin oder einem Derivat des Benzoins, das noch die Hydroxylgruppe des Benzoins enthält, mit tertiärem Amin in Abwesenheit von direkt an Silicium gebundenem Halogen, von Säure, die saurer ist

als Benzoin bzw. als das jeweils verwendete Benzoin-Derivat, von Base, die basischer ist als das jeweils verwendete tertiäre Amin und von 1000 Gewichtsprozent, bezogen auf das Gesamtgewicht der jeweils eingesetzten Menge von tertiärem Amin und Benzoin bzw. mit tertiärem Amin umzusetzendem Benzoin-Derivat übersteigenden Mengen von Stoff, dessen Vernetzung durch Licht initiiert werden soll, erhältlich sind.

Gegenstand der Erfindung ist weiterhin ein Verfahren zur Herstellung von neuen Benzoin-Derivaten, dadurch gekennzeichnet, daß Benzoin oder ein Derivat des Benzoins, das noch die Hydroxylgruppe des Benzoins enthält, mit tertiärem Amin in Abwesenheit von direkt an Silicium gebundenem Halogen, von Säure, die saurer ist als Benzoin bzw. als das jeweils verwendete Benzoin-Derivat, von Base, die basischer ist als das jeweils verwendete tertiäre Amin und von 1000 Gewichtsprozent, bezogen auf das Gesamtgewicht der jeweils eingesetzten Menge von tertiärem Amin und Benzoin bzw. mit tertiärem Amin umzusetzendem Benzoin-Derivat, übersteigenden Mengen von Stoff, dessen Vernetzung durch Licht initiiert werden soll, umgesetzt wird.

Die Benzoin-Derivate, durch deren Umsetzung mit tertiärem Amin unter den oben angegebenen Voraussetzungen erfindungsgemäße Benzoin-Derivate erhältlich sind, und damit Benzoin-Derivate, die bei dem erfindungsgemäßen Verfahren eingesetzt werden können, sind vorzugsweise solche der Formel

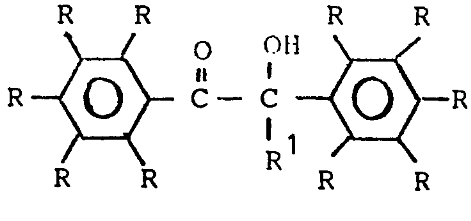

worin R und $R^1$ jeweils gleiche oder verschiedene, gegenüber dem jeweils verwendeten Amin bei der jeweiligen Umsetzungstemperatur inerte Substituenten oder Wasserstoff bedeuten mit der Maßgabe, daß $R^1$ oder mindestens einer der Substituenten R nicht Wasserstoff ist.

Beispiele für Substituenten R sind Halogenatome, wie Chlor; die Nitrogruppe, Alkoxyreste, wie der Methoxyrest; Aryloxyreste,wie der Phenoxyrest; Alkylreste, wie der Methyl-, Ethyl-, n- und tert.-Butylrest; Cycloalkylreste, wie der Cyclohexylrest; Arylreste, wie der Phenylrest; Alkarylreste, wie Tolylreste; Aralkylreste, wie der Benzylrest; Alkoxyarylreste, wie der p-Methoxyphenylrest; Triorganosiloxygruppen, wie die Trimethylsiloxy- und die Phenyldimethylsiloxygruppe und durch Triorganosiloxygruppen substituierte Alkylgruppen, wie der Trimethylsiloxymethyl- und der 2-Trimethylsiloxyethylrest. Es können auch mindestens zwei einander benachbarte Substituenten R einen anellierten aromatischen Rest bilden.

Schon wegen der leichteren Zugänglichkeit ist die Verwendung von Benzoin gegenüber der Verwendung eines Benzoin-Derivats als Ausgangsprodukt bevorzugt.

Die Beispiele für die Substituenten R gelten mit Ausnahme der Halogenatome, der Nitrogruppe, der Triorganosiloxygruppen, die nicht als Substituenten von Alkylgruppen vorliegen, und selbstverständlich auch der miteinander verbundenen Substituenten R auch für die Substituenten $R^1$.

Wenn anstelle von Benzoin ein Benzoin-Derivat als Ausgangsprodukt verwendet wird, so ist als derartiges Derivat die Verbindung der Formel

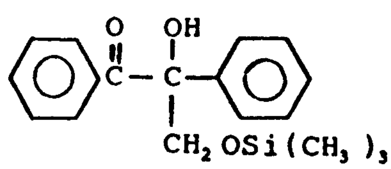

bevorzugt.

Bei dem erfindungsgemäßen Verfahren können als tertiäre Amine beliebige tertiäre Amine eingesetzt werden, insbesondere solche, die auch bisher in durch Licht vernetzbaren Zusammensetzungen als Aktivatoren oder Promotoren vorliegen konnten. Beispiele für derartige Amine sind Triethanolamin, 4-(N,N-Dimethylamino)-pyridin, N,N-Dimethylcyclohexylamin, Dimethylethanolamin, Tribenzylamin, N,N-Dimethylanilin, Dimethylphenylamin, Dibenzylethanolamin, N-Benzyl-N-methylethanolamin, Triisopropylamin, 2-Hydroxyethyldiisopropylamin, N-2-Hydroxymorpholin und 3-Dimethylamino-2,2-dimethylpropanol-1. Triethanolamin ist bevorzugt.

Zur Herstellung der erfindungsgemäßen Benzoin-Derivate bzw. bei dem erfindungsgemäßen Verfahren wird tertiäres Amin vorzugsweise in Mengen von 0,5 bis 10 Mol je Mol Benzoin bzw. Benzoin-Derivat eingesetzt. Besonders bevorzugt ist ein Molverhältnis von 1:1 oder etwa 1:1.

Die Umsetzung von Benzoin bzw. Benzoin-Derivat mit tertiärem Amin zu erfindungsgemäßem Benzoin-Derivat erfolgt nach Vermischen der Reaktionsteilnehmer in Abwesenheit von direkt an Silicium gebundenem Halogen, von Säure, die saurer ist als Benzoin bzw. als das jeweils verwendete Benzoin-Derivat, von Base, die basischer ist als das jeweils verwendete tertiäre Amin und von 1000 Gewichtsprozent, vorzugsweise 200 Gewichtsprozent und möglichst auch 0 Gewichtsprozent, jeweils bezogen auf das Gesamtgewicht der jeweils eingesetzten Menge von tertiärem Amin und Benzoin bzw. mit dem tertiären Amin umzusetzendem Benzoin-Derivat, übersteigenden Mengen von Stoff, dessen Vernetzung durch Licht initiiert werden soll.

Bei Raumtemperatur benötigt diese Umsetzung mehrere Wochen. Deshalb wird das Gemisch der Reaktionsteilnehmer vorzugsweise 0,5 bis 5 Stunden auf 50°C bis 200°C erwärmt. Der Druck bei dieser Umsetzung ist vorzugsweise derjenige der umgebenden Atmosphäre, also 1020 hPa (abs.) oder etwa 1020 hPa (abs.). Falls erwünscht können aber auch höhere oder niedrigere Drücke angewendet werden.

Die Umsetzung von Benzoin bzw. Benzoin-Derivat mit tertiärem Amin zu erfindungsgemäßem Benzoin-Derivat kann ohne Mitverwendung eines Lösungsmittels durchgeführt werden. Vorzugsweise wird diese Umsetzung jedoch in einem Lösungsmittel, worin die genannten Reaktionsteilnehmer gut löslich sind, wie Toluol, durchgeführt. Nach Beendigung der Umsetzung wird das Lösungsmittel vorzugsweise entfernt, z.B. durch Filtrieren, Destillation oder Schleudern und Abdekantieren.

Gegenstand der Erfindung sind schließlich auch durch Licht vernetzbare Zusammensetzungen auf Grundlage von mindestens einer Verbindung mit mindestens einer durch Licht polymerisierbaren Kohlenstoff-Kohlenstoff-Doppelbindung und mindestens einem Benzoin-Derivat als Photoinitiator, dadurch gekennzeichnet, daß das Benzoin-Derivat solches ist, das durch Umsetzung von Benzoin oder einem Derivat des Benzoins, das noch die Hydroxylgruppe des Benzoins enthält, mit tertiärem Amin in Abwesenheit von direkt an Silicium gebundenem Halogen, von Säure, die saurer ist als Benzoin bzw. das jeweils

verwendete Benzoin-Derivat, von Base, die basischer ist als das jeweils verwendete tertiäre Amin und von 1000 Gewichtsprozent, bezogen auf das Gesamtgewicht der jeweils eingesetzten Menge von tertiärem Amin und Benzoin bzw. mit tertiärem Amin umzusetzendem Benzoin-Derivat, übersteigenden Mengen von Stoff, dessen Vernetzung durch Licht initiiert werden soll, erhältlich ist.

Abgesehen von dem Gehalt an erfindungsgemäßem oder erfindungsgemäß hergestelltem Benzoin-Derivat können die erfindungsgemäßen durch Licht vernetzbaren Zusammensetzungen beispielsweise die gleichen sein, wie die bisher bekannten durch Licht vernetzbaren Zusammensetzungen.

Beispiele für Verbindungen mit mindestens einer durch Licht polymerisierbaren Kohlenstoff-Kohlenstoff-Doppelbindung sind Gemische aus Hexan-1,6-dioldiacrylat und einem Umsetzungsprodukt aus Bisphenol-A-Diglycidylether mit zwei Äquivalenten Acrylsäure, Teilhydrolysate von gamma-Acryloxypropyltrimethoxysilan, Pentaerytrittrimethacrylat, Triethylenglykoldimethacrylat, das Organopolysiloxan der Formel

$$A(CH_3)_2SiO[Si(CH_3)_2O]_nSi(CH_3)_2A \quad ,$$

wobei n den Durchschnittswert von 22 hat und A den Rest der Formel

$$H_2C{=}CHCOO(CH_2)_2OOCCH_2CH(COOH)(CH_2)_3 -$$

oder

$$H_2C{=}CHCOO(CH_2)_2OOCCH(CH_2(CH_2)_2-)CH_2COOH$$

bedeutet, Polyester(meth)acrylate, Urethan(meth)acrylate, Ethylacrylat, Triethylenglykoldiacrylat, Mischpolymerisate

0214665

aus Einheiten der Formel

$$H_2C{=}CCH_3COO(CH_2)_3SiO_{3/2}$$

und $(CH_3)_3SiO_{1/2}$

sowie Gemische aus (A) Mischpolymerisaten aus Einheiten der Formel

$$H_2C{=}CHCOO(CH_2)_3Si(CH_3)_2O_{1/2}$$

und $(CH_3)_2SiO$

und (B) durch Trimethylsiloxygruppen endblockierten Organopolysiloxanen mit 0,05 bis 5 Molprozent Einheiten der Formel

$$HS(CH_2)_3SiO_{3/2} \quad .$$

Vorzugsweise enthalten die erfindungsgemäßen durch Licht vernetzbaren Zusammensetzungen die erfindungsgemäßen bzw. erfindungsgemäß hergestellten Benzoin-Derivate in Mengen von 0,05 bis 10 Gewichtsprozent, bezogen auf das Gesamtgewicht aller Bestandtiele der jeweiligen durch Licht vernetzbaren Zusammensetzung.

Zusätzlich zu Verbindung mit mindestens einer durch Licht polymerisierbaren Kohlenstoff-Kohlenstoff-Doppelbindung und erfindungsgemäßem bzw. erfindungsgemäß hergestelltem Benzoin-Derivat können die erfindungsgemäßen Zusammensetzungen Zusatz- oder Hilfsstoffe enthalten, wie sie üblicherweise in durch Licht polymerisierbaren Zusammensetzungen enthalten sein können. Beispiele für derartige Zusätze sind insbesondere Inhibitoren gegen die thermische Polymerisation, organische Lösungsmittel und Füllstoffe, wie Siliciumdioxyd mit einer Oberfläche von mindestens 50 $m^2/g$, Quarzmehl, Pulver aus Barium enthaltendem Glas, Aluminiumoxyd und Pulver aus Glas, das Lanthan-, Hafnium-, Strontium- oder Tantalverbindungen enthält. Alle diese Füllstoffe können gegebenenfalls auf ihrer Oberfläche Organosilylgruppen, wie gamma-Methacryloxypropylsiloxygruppen, aufweisen.

Die erfindungsgemäßen durch Licht vernetzbaren Zusammensetzungen können durch Ultraviolett-Licht oder Licht mit einer Wellenlänge im Bereich von 400 bis 600 nm oder einem Gemisch dieser beiden Arten von Licht vernetzt werden.

Die erfindungsgemäßen durch Licht vernetzbaren Zusammensetzungen eignen sich zur Füllung von Hohlräumen in menschlichen und tierischen Zähnen, als Knochenzement, zur Verklebung von Gegenständen aus silikatischen Werkstoffen, wie Glas oder Porzellan, zur Herstellung von Überzügen, z.B. auf Papier oder Glas, einschließlich Lichtleitfasern, zum Einbetten von elektronischen Bauteilen und für alle übrigen Zwecke, für die auch bisher durch Licht vernetzbare Massen eingesetzt werden konnten.

In den folgenden Beispielen beziehen sich alle Angaben von Prozentsätzen auf das Gewicht, soweit nichts anderes angegeben ist.

<u>Beispiel 1</u>

a) Ein Gemisch aus 21,2 g Benzoin, 14,9 g Triethanolamin und 100 g Toluol wird zwei Stunden unter Rühren zum Sieden unter Rückfluß erwärmt. Nach Abdestillieren des Lösungsmittels bei 16 hPa (abs.) wird als Rückstand eine gelbliche kristalline Masse erhalten. Diese Masse hat einen Schmelzpunkt von 50°C und einen Spezifischen Widerstand von 10 M Ohm/cm, während der Spezifische Widerstand von Benzoin mehr als 200 M Ohm/cm und der Spezifische Widerstand von Triethanolamin 150 M Ohm/cm beträgt und die Mischung aus 1 Mol Benzoin und 1 Mol Triethanolamin einen Spezifischen

Widerstand von ebenfalls mehr als 200 M Ohm/cm hat.

b) Zu einer Lösung von 1240 g (5 Mol) gamma-Methacryloxypropyltrimethoxysilan und 108 g (0,67 Mol) Hexamethyldisiloxan in 1250 g Toluol werden 146 g 1-n-Salzsäure (0,15 Mol HCl) und 130 g (7,2 Mol) entionisiertes Wasser gegeben. Die so erhaltene Mischung wird unter Rühren eine Stunde zum Sieden unter Rückfluß erwärmt und dann mit 15 g (0,15 Mol) Calciumcarbonat neutralisiert. Aus der so erhaltenen Mischung werden nach dem Filtrieren die bei 130 Pa (abs.) bis zu 80°C siedenden Bestandteile abdestilliert.

c) Eine Zusammensetzung aus

| | | |
|---|---|---|
| 23,5 | % | des gemäß b) hergestellten Öls |
| 4,6 | % | Triethylenglykoldimethylacrylat |
| 3,4 | % | pyrogen erzeugtem Siliciumdioxyd mit einer Oberfläche von etwa 200 $m^2/g$ |
| 63,5 | % | Quarzmehl |
| 5 | % | des gemäß a) hergestellten Benzoin-Derivats |

wird in zylindrische Formen mit einem Durchmesser von 3 mm eingebracht. Ein Teil dieser Formen wird mit einer handelsüblichen Ultraviolett-Lampe ("Litema Pluraflex UV 200", wobei es sich bei "Litema Pluraflex" um ein Registriertes Warenzeichen handeln dürfte), der Rest dieser Formen mit einem handelsüblichem Halogenlichtgerät ("Heliomat Type H 2", wobei es sich bei dem Wort "Heliomat" um ein Registriertes Warenzeichen handeln dürfte) belichtet. Innerhalb von 30 Sekunden wird mit dem Ultraviolett-Licht eine Vernetzung bis in eine Tiefe von 3,4 mm und mit dem Halogenlicht eine Vernetzung bis in eine Tiefe von 3,3 mm erzielt.

Vergleichsversuch a

Die in Beispiel 1 unter c) beschriebene Arbeitsweise wird wiederholt mit der Abänderung, daß anstelle der 5 % des Benzoin-Derivats, dessen Herstellung in Beispiel 1 unter a) beschrieben wurde,

5 % einer frisch bereiteten Mischung aus Benzoin und Triethanolamin im Molverhältnis von 1:1 verwendet werden. Innerhalb von 30 Sekunden wird mit dem Ultraviolett-Licht eine Vernetzung bis in eine Tiefe von nur 2,1 mm und mit dem Halogenlicht keinerlei Vernetzung erzielt.

Beispiel 2

a) Die in Beispiel 1 unter a) beschriebene Arbeitsweise wird wiederholt mit der Abänderung, daß 12,2 g 4-(N,N-Dimethylamino)-pyridin anstelle der 14,9 g Triethanolamin verwendet werden. Es wird eine gelbe kristalline Masse in einer Ausbeute von 31,5 g (94 % d.Th.) mit einem Spezifischen Widerstand von 12,5 M Ohm/cm erhalten. Der Spezifische Widerstand von 4-(N,N-Dimethylamino)-pyridin beträgt mehr als 200 M Ohm/cm.

b) Die in Beispiel 1 unter c) beschriebene Arbeitsweise wird wiederholt mit der Abänderung, daß 5 % des Benzoin-Derivats, dessen Herstellung vorstehend unter a) beschrieben wurde, anstelle der 5 % des Benzoin-Derivats, dessen Herstellung in Beispiel 1 unter a) beschrieben wurde, verwendet werden. Innerhalb von 30 Sekunden wird mit dem Ultraviolett-Licht eine Vernetzung bis in eine Tiefe von 1 mm und mit dem Halogen-Licht eine Vernetzung bis in eine Tiefe von 2 mm erzielt.

Vergleichsversuch b

Die in Beispiel 1 unter c) beschriebene Arbeitsweise wird wiederholt mit der Abänderung, daß anstelle der 5 % des Benzoin-Derivats, dessen Herstellung in Beispiel 1 unter a) beschrieben wurde, 5 % einer frisch bereiteten Mischung aus Benzoin und 4-(N,N-Dimethylamino)-pyridin im Molverhältnis von 1:1 verwendet werden. Innerhalb von 30 Sekunden wird weder mit Ultraviolett- noch mit Halogenlicht eine Vernetzung erzielt.

0214665

Beispiel 3

a) Die in Beispiel 1 unter a) beschriebene Arbeitsweise wird wiederholt mit der Abänderung, daß anstelle der 14,9 g Triethanolamin 12,7 g N,N-Dimethylcyclohexylamin verwendet werden. Es werden weiße Kristalle mit einem Schmelzpunkt von 109°C in einer Ausbeute von 32,3 g (95 % d.Th.) erhalten.

b) Die in Beispiel 1 unter c) beschriebene Arbeitsweise wird wiederholt mit der Abänderung, daß 5 % des Benzoin-Derivats, dessen Herstellung vorstehend unter a) beschrieben wurde, anstelle der 5 % des Benzoin-Derivats, dessen Herstellung in Beispiel 1 unter a) beschrieben wurde, verwendet werden. Innerhalb von 30 Sekunden wird mit dem Ultraviolett-Licht eine Vernetzung bis in eine Tiefe von 2,2 mm und mit dem Halogenlicht eine Vernetzung bis in eine Tiefe von 2,85 mm erzielt.

Vergleichsversuch c

Die in Beispiel 1 unter c) beschriebene Arbeitsweise wird wiederholt mit der Abänderung, daß anstelle der 5 % des Benzoin-Derivats, dessen Herstellung in Beispiel 1 unter a) beschrieben wurde, 5 % einer frisch bereiteten Mischung aus Benzoin und N,N-Dimethylcyclohexylamin im Molverhältnis von 1:1 verwendet werden. Innerhalb von 30 Sekunden wird mit dem Ultraviolett-Licht eine Vernetzung bis in eine Tiefe von 1,6 mm und mit dem Halogenlicht eine Vernetzung bis in eine Tiefe von 2,2 mm erzielt.

Beispiel 4

Die in Beispiel 1 unter a) beschriebene Arbeitsweise wird wiederholt mit der Abänderung, daß 31,4 g der Verbindung der Formel

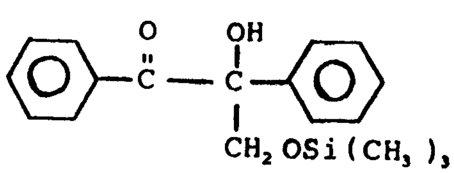

anstelle der 21,2 g Benzoin verwendet werden. Es werden in einer Menge von 45,3 g (98 % d. Th.) gelbliche Kristalle mit einem Schmelzpunkt von 60°C und einem Spezifischen Widerstand von 90 M Ohm/cm erhalten. Der Spezifische Widerstand der Verbindung der vorstehend angegebenen Formel beträgt mehr als 200 M Ohm/cm.

b) Die in Beispiel 1 unter c) beschriebene Arbeitsweise wird wiederholt mit der Abänderung, daß 5 % des Benzoin-Derivats, dessen Herstellung vorstehend unter a) beschrieben wurde, anstelle der 5 % des Benzoin-Derivats dessen Herstellung in Beispiel 1 unter a) beschrieben wurde, verwendet werden. Innerhalb von 30 Sekunden wird mit dem Ultraviolett-Licht eine Vernetzung bis in eine Tiefe von 2 mm und mit dem Halogenlicht eine Vernetzung bis in eine Tiefe von 1 mm erzielt.

Vergleichsversuch c

Die in Beispiel 1 unter c) beschriebene Arbeitsweise wird wiederholt mit der Abänderung, daß anstelle der 5 % des Benzoin-Derivats, dessen Herstellung in Beispiel 1 unter a) beschrieben wurde, 5 % einer frisch bereiteten Mischung aus dem Benzoin-Derivat der in Beispiel 4 unter a) angegebenen Formel und Triethanolamin im Molverhältnis 1:1 eingesetzt werden. Innerhalb von 30 Sekunden wird mit dem Ultraviolett-Licht nur eine Vernetzung an der Oberfläche und mit dem Halogenlicht gar keine Vernetzung beobachtet.

Die Verbindung der Formel

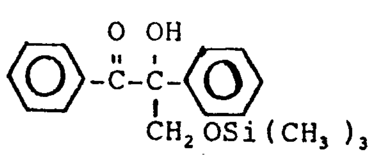

wurde hergestellt wie folgt:

1 Mol Benzoin wird in 1000 ml Toluol gelöst. Die so erhaltene Lösung wird mit 20 ml einer 3 Gew.-%-igen Lösung von Kaliumhydroxid in Methanol vermischt, auf 80°C erwärmt und innerhalb 8 Stunden mit 1,2 Mol Paraformaldehyd versetzt. Die Lösungsmittel werden dann bei etwa 1 hPa (abs.) abgedampft und der Rückstand wird in Toluol umkristallisiert. Die so erhaltenen Kristalle werden in 1000 ml Toluol gelöst. Die so erhaltene Lösung wird mit 1 Mol Hexamethyldisilazan und 1 Mol Trimethylchlorsilan vermischt und 4 Stunden zum Sieden unter Rückfluß erwärmt. Nach dem Abfiltrieren von Feststoffen wird das Lösungsmittel bei etwa 1 hPa (abs.) abgedampft. Es hinterbleibt ein gelbliches Öl, das beim Stehenlassen kristallisiert.

0214665

P a t e n t a n s p r ü c h e :

1. Benzoin-Derivate, d a d u r c h g e k e n n z e i c h n e t, daß sie durch Umsetzung von Benzoin oder einem Derivat des Benzoins, das noch die Hydroxylgruppe des Benzoins enthält, mit tertiärem Amin in Abwesenheit von direkt an Silicium gebundenem Halogen, von Säure, die saurer ist als Benzoin bzw. als das jeweils verwendete Benzoin-Derivat, von Base, die basischer ist als das jeweils verwendete tertiäre Amin und von 1000 Gewichtsprozent, bezogen auf das Gesamtgewicht der jeweils eingesetzten Menge von tertiärem Amin und Benzoin bzw. mit tertiärem Amin umzusetzenden Benzoin-Derivat, übersteigenden Mengen von Stoff, dessen Vernetzung durch Licht initiiert werden soll, erhältlich sind.

2. Benzoin-Derivate nach Anspruch 1, d a d u r c h g e k e n n z e i c h n e t, daß das tertiäre Amin Triethanolamin, 4-(N,N-Dimethylamino)-pyridin oder N,N-Dimethylcyclohexylamin ist.

3. Benzoin-Derivate nach Anspruch 1 oder 2, d a d u r c h g e k e n n z e i c h n e t, daß ein mit tertiärem Amin umzusetzendes Benzoin-Derivat solches der Formel

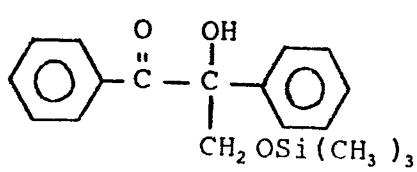

ist.

4. Verfahren zur Herstellung von neuen Benzoin-Derivaten, d a d u r c h g e k e n n z e i c h n e t, daß Benzoin oder ein Derivat des Benzoins, das noch die Hydroxylgruppe des Benzoins enthält, mit tertiärem Amin in Abwesenheit von direkt an Silicium gebundenem Halogen, von Säure, die saurer ist als Benzoin bzw. als das jeweils verwendete Benzoin-Derivat, von Base, die basischer ist als das jeweils verwendete tertiäre Amin und von 1000 Gewichtsprozent, bezogen auf das Gesamtgewicht der jeweils eingesetzten Menge von tertiärem Amin und Benzoin bzw. mit tertiärem Amin umzusetzendem Benzoin-Derivat, übersteigenden Mengen von Stoff, dessen Vernetzung durch Licht initiiert werden soll, umgesetzt wird.

5. Verfahren nach Anspruch 4, dadurch gekennzeichnet, daß als tertiäres Amin Triethanolamin, 4-(N,N-Dimethylamino)-pyridin oder N,N-Dimethylcyclohexylamin verwendet wird.

6. Verfahren nach Anspruch 4 oder 5, dadurch gekennzeichnet, daß als mit tertiärem Amin umzusetzendes Benzoin-Derivat solches der Formel

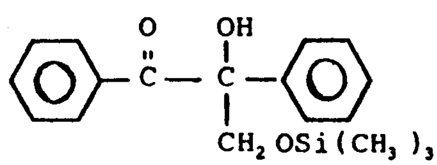

verwendet wird.

7. Verfahren nach mindestens einem der Ansprüche 4 bis 6, dadurch gekennzeichnet, daß das Gemisch aus Benzoin bzw. mit tertiärem Amin umzusetzendem Benzoin-Derivat und tertiärem Amin 0,5 bis 5 Stunden auf 50°C bis 200°C erwärmt wird.

8. Durch Licht vernetzbare Zusammensetzungen auf Grundlage von mindestens einer Verbindung mit mindestens einer durch

Licht polymerisierbaren Kohlenstoff-Kohlenstoff-Doppelbindung und mindestens einem Benzoin-Derivat als Photoinitiator, d a d u r c h g e k e n n z e i c h n e t, daß das Benzoin-Derivat solches ist, das durch Umsetzung von Benzoin oder einem Derivat des Benzoins, das noch die Hydroxylgruppe des Benzoins enthält, mit tertiärem Amin in Abwesenheit von direkt an Silicium gebundenem Halogen, von Säure, die saurer ist als Benzoin bzw. als das jeweils verwendete Benzoin-Derivat, von Base, die basischer ist als das jeweils verwendete tertiäre Amin und von 1000 Gewichtsprozent, bezogen auf das Gesamtgewicht der jeweils eingesetzten Menge von tertiärem Amin und Benzoin bzw. mit tertiärem Amin umzusetzendem Benzoin-Derivat, übersteigenden Mengen von Stoff, dessen Vernetzung durch Licht initiiert werden soll, erhältlich ist.

Patentansprüche für AT:

1. Verfahren zur Herstellung von neuen Benzoin-Derivaten, d a d u r c h g e k e n n z e i c h n e t, daß Benzoin oder ein Derivat des Benzoins, das noch die Hydroxylgruppe des Benzoins enthält, mit tertiärem Amin in Abwesenheit von direkt an Silicium gebundenem Halogen, von Säure, die saurer ist als Benzoin bzw. als das jeweils verwendete Benzoin-Derivat, von Base, die basischer ist als das jeweils verwendete tertiäre Amin und von 1000 Gewichtsprozent, bezogen auf das Gesamtgewicht der jeweils eingesetzten Menge von tertiärem Amin und Benzoin bzw. mit tertiärem Amin umzusetzendem Benzoin-Derivat, übersteigenden Mengen von Stoff, dessen Vernetzung durch Licht initiiert werden soll, umgesetzt wird.

2. Verfahren nach Anspruch 1, d a d u r c h g e k e n n z e i c h n e t, daß als tertiäres Amin Triethanolamin, 4-(N,N-Dimethylamino)-pyridin oder N,N-Dimethylcyclohexylamin verwendet wird.

3. Verfahren nach Anspruch 1 oder 2, d a d u r c h g e k e n n z e i c h n e t, daß als mit tertiärem Amin umzusetzendes Benzoin-Derivat solches der Formel

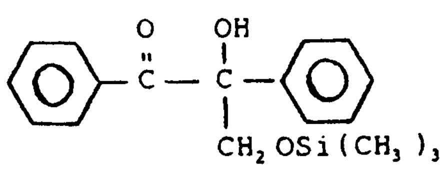

verwendet wird.

4. Verfahren nach mindestens einem der Ansprüche 1 bis 3, d a d u r c h g e k e n n z e i c h n e t, daß das Gemisch aus Benzoin bzw. mit tertiärem Amin umzusetzendem Benzoin-Derivat und tertiärem Amin 0,5 bis 5 Stunden auf 50°C bis 200°C erwärmt wird.

5. Durch Licht vernetzbare Zusammensetzungen auf Grundlage von mindestens einer Verbindung mit mindestens einer durch Licht polymerisierbaren Kohlenstoff-Kohlenstoff-Doppelbindung und mindestens einem Benzoin-Derivat als Photoinitiator, d a d u r c h g e k e n n z e i c h n e t, daß das Benzoin-Derivat solches ist, das durch Umsetzung von Benzoin oder einem Derivat des Benzoins, das noch die Hydroxylgruppe des Benzoins enthält, mit tertiärem Amin in Abwesenheit von direkt an Silicium gebundenem Halogen, von Säure, die saurer ist als Benzoin bzw. als das jeweils verwendete Benzoin-Derivat, von Base, die basischer ist als das jeweils verwendete tertiäre Amin und von 1000 Gewichtsprozent, bezogen auf das Gesamtgewicht der jeweils eingesetzten Menge von tertiärem Amin und Benzoin bzw. mit tertiärem Amin umzusetzendem Benzoin-Derivat, übersteigenden Mengen von Stoff, dessen Vernetzung durch Licht initiiert werden soll, erhältlich ist.